# EUROPÄISCHE PATENTSCHRIFT

(11) **EP 2 845 240 B1**
(45) Veröffentlichungstag und Bekanntmachung des Hinweises auf die Patenterteilung: **21.03.2018**
(21) Anmeldenummer: 13724548.6
(22) Anmeldetag: 14.05.2013
(51) Int. Cl.: H01L 51/54

(54) **METALLKOMPLEXE ALS P-DOTANDEN FÜR ORGANISCHE ELEKTRONISCHE MATRIXMATERIALIEN**
METAL COMPLEXES AS P-TYPE DOPANTS FOR ORGANIC ELECTRONIC MATRIX MATERIALS
COMPLEXES MÉTALLIQUES UTILISÉS COMME DOPANTS P DANS DES MATÉRIAUX DE MATRICES ÉLECTRONIQUES ORGANIQUES

(30) Priorität: 06.06.2012 DE 102012209520
(43) Veröffentlichungstag der Anmeldung: 11.03.2015
(73) Patentinhaber: Siemens Aktiengesellschaft, 80333 München (DE); OSRAM OLED GmbH, 93049 Regensburg (DE)
(72) Erfinder: MALTENBERGER, Anna, 91359 Leutenbach (DE); SCHMID, Günter, 91334 Hemhofen (DE); WEMKEN, Jan Hauke, 90449 Nürnberg (DE); PECQUEUR, Sébastien, F-62136 La Couture (FR)
(74) Vertreter: Michalski Hüttermann & Partner Patentanwälte mbB
(86) Internationale Anmeldenummer: PCT/EP2013/059868
(87) Internationale Veröffentlichungsnummer: WO 2013/182383

(56) Entgegenhaltungen:
- EP-A1- 2 276 086
- WO-A1-2011/033023

## Beschreibung

Die Erfindung betrifft die Verwendung bi- oder polynuclearer Metallkomplexe als p-Dotanden für organisch elektronische Matrixmaterialien.

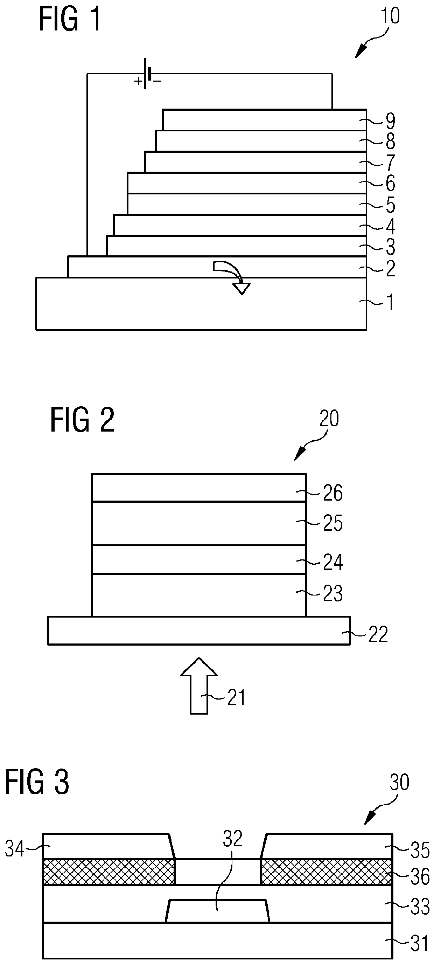

Innerhalb der organischen Elektronik lassen sich im Wesentlichen zwei wichtige kommerzielle Technologiefelder herausarbeiten. Das erste Technologiefeld beschäftigt sich dabei mit Anwendungen organischer Matrixmaterialien zur Umwandlung von Licht in elektrischen Strom und umgekehrt und das andere Feld fokussiert sich auf den Aufbau elektrischer Bauteile mittels organischem Halbleitermaterial. Beispiele für die erstgenannte Kategorie liefern zum Beispiel Fotodetektoren und organische Solarzellen, schematisch dargestellt in Figur 1, welche Licht in ein elektrisches Signal oder in elektrischen Strom umwandeln und organische Leuchtdioden (OLEDs), welche Licht mittels organischer elektronischer Materialien erzeugen können (siehe Figur 2). In den zweiten Technologiebereich fallen zum Beispiel organische Feldeffekt-Transistoren, schematisch dargestellt in Figur 3, bei denen eine Dotierung den Kontaktwiderstand zwischen Elektrode und Halbleitermaterial verringert oder bipolare Transistoren.

Allen Anwendungen ist gemein, dass sie als wesentliche, funktionale Komponente elektrische Transportschichten beinhalten, welche in Abhängigkeit ihrer Zusammensetzung unterschiedliche Leitungsmechanismen aufweisen. Allgemein unterscheidet man eine intrinsische p-(Loch)- oder eine n-(Elektronen)-Leitfähigkeit der organischen Materialien. Da die elektrischen Eigenschaften dieser organischen Substanzklassen in der Regel für eine hoch effiziente Nutzung der Bauteile unzureichend sind, werden diese mit zusätzlichen Verbindungen versetzt, welche die elektrischen Eigenschaften der Schichten verbessern sollen. Üblicherweise erfolgt dies durch Dotieren mit metallischen oder weiteren organischen Verbindungen. Ein Ansatz zur Erzielung signifikanter Verbesserungen der Leitfähigkeiten ist der Zusatz von Metallkomplexen und insbesondere der Zusatz von Übergangsmetallkomplexen.

So beschreibt zum Beispiel die WO 2005 086251 Dotanden zur Herstellung von n-leitenden Schichten, welche unter anderem auch folgende Struktur aufweisen können:

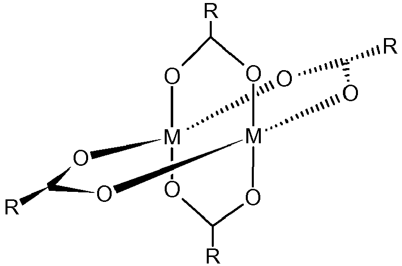

Die Struktur dieser Verbindungsklasse wird in der Literatur auch als Schaufelradkomplex "paddle wheel complex" bezeichnet. Insbesondere beschreibt die Veröffentlichung die Verwendung eines Metallkomplexes als n-Dotand zur Dotierung eines organischen halbleitenden Matrixmaterials zur Veränderung der elektrischen Eigenschaften desselben. Die vorgestellten Verbindungen sollen bezüglich des Matrixmaterials als n-Dotanden einsetzbar sein.

Einen anderen Weg unter Verwendung Lewis-saurer Metallkomplexe zur Dotierung von p-leitenden Transportschichten gibt dagegen Endo et al. (Jpn. J. Appl. Phys. Vol. 41 (2002) L358-L360) an. In dieser Literaturestelle werden organische elektrolumineszierende Vorrichtungen beschrieben, welche eine p-leitende Schicht aufweisen, die mittels einer Co-Dotierung aus FeCl₃ und Arylamin-Derivaten, wie z.B. N,N'-dinapthyl-N,N-diphenyl benzidine (α-NPD), hergestellt werden. Allerdings werden dort auch signifikante Nachteile für das Bauteil, wie Löschung der Lumineszenz und Erhöhung der Eigenabsorption beschrieben.

Eine weitere Möglichkeit zu Ausgestaltung organischer Halbleiter für bipolare Feldeffekttransistoren durch Dotierung wird zudem in der DE 102010041331 offenbart.

Des weiteren offenbart die EP 227 608 6 A1 eine Vorrichtung mit einem Substrat, zwei oder mehr einander zugewandten Elektroden, die auf dem Substrat angeordnet sind, und einer positiven Löcherinjektionstransportschicht, die zwischen zwei Elektroden zwischen den zwei oder mehr Elektroden angeordnet ist, wobei die positive Löcherinjektionstransportschicht ein Reaktionsprodukt eines Molybdänkomplexes oder Wolframkomplex ist.

Eine weitere Ausgestaltung eines organisch elektronischen Bauelementes ist in der WO 2011 033 023 A1 beschreiben. Das organische Bauelement umfasst ein Substrat, eine erste Elektrode, die auf dem Substrat angeordnet ist, mindestens eine erste funktionelle organische Schicht, die auf der ersten Elektrode angeordnet ist, eine zweite Elektrode, die auf der ersten funktionellen organischen Schicht angeordnet ist, wobei die erste funktionelle organische Schicht ein Matrixmaterial und einen p-Dotierstoff in Bezug auf das Matrixmaterial umfasst, dadurch gekennzeichnet, dass der p-Dotierstoff einen Lewis-sauren Kupferkomplex umfasst und das Matrixmaterial eine Lewis-basische Verbindung ist, die an die freien Koordinationsstellen der Kupferatome koordiniert.

Es stellt sich jedoch die Aufgabe, weitere Materialien zu finden, welche als sich als p-Dotanden in organisch elektronische Matrixmaterialien, insbesondere Lochtransportern eignen und die Effizienz von Bauteilen enthaltend diese Schichten erhöhen.

Gelöst wird diese Aufgabe durch ein organisches elektronisches Bauteil gemäß Anspruch 1 der vorliegenden Erfindung.

Demgemäß wird ein organisches elektronisches Bauteil mit einer Matrix vorgeschlagen, wobei die Matrix als p-Dotand einen Austauschseite bi- oder polynuclearen Gruppe V b/ VI b / VII b bzw. Gruppe 5-7 Metallkomplex enthält, der wiederum mindestens einen Liganden L der folgenden Struktur enthält:

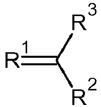

wobei R¹ und R² unabhängig voneinander Sauerstoff, Schwefel, Selen, NH oder NR⁴ sein können, wobei R⁴ ausgewählt ist aus der Gruppe enthaltend Alkyl oder Aryl und mit R³ verbunden sein kann; und

R³ ausgewählt ist aus der Gruppe enthaltend Alkyl, langkettiges Alkyl, Alkoxy, langkettiges Alkoxy, Cycloalkyl, Halogenalkyl, Aryl, Arylene, Halogenaryl, Heteroaryl, Heteroarylene, Heterocycloalkylene, Heterocycloalkyl, Halogenheteroaryl, Alkenyl, Halogenalkenyl, Alkinyl, Halogenalkinyl, Ketoaryl, Halogenketoaryl, Ketoheteroaryl, Ketoalkyl, Halogenketoalkyl, Ketoalkenyl, Halogenketoalkenyl, wobei bei geeigneten Resten eine oder mehrere nicht-benachbarte CH₂-Gruppen unabhängig voneinander durch -O-, -S-, -NH-, -CO-, -COO-, - OCO-, -OCO-O-, -SO2-, -S-CO-, -CO-S-, -CY1=CY2 oder Austauschseite C=C- ersetzt sein können und zwar derart, dass 0 und/oder S Atome nicht direkt miteinander verbunden sind, ebenfalls optional mit Aryl- oder Heteroaryl bevorzugt enthaltend 1 bis 30 C-Atome ersetzt sind (endständige CH₃-Gruppen werden wie CH₂-Gruppen im Sinne von CH₂-H verstanden).

Überraschend hat sich herausgestellt, dass diese Materialien als p-Dotanden für Matrixmaterialien in organischen elektronischen Bauteilen geeignet sind. Insbesondere weisen diese Materialien oftmals einen oder mehrere der folgenden Vorteile auf
- Die Materialien sind gut zusammen aus zwei getrennten Quellen mit dem Matrixmaterial co-evaporierbar, so dass sich dotierte Matrixschichten definierter Zusammensetzung bilden
- Die Materialien sind auf einfachem Wege erhältlich und benötigen keine aufwendigen Herstellungsprozesse
- Die Dotierstärke ist der Matrix anpassbar
- Die Leitfähigkeit kann über die Konzentration und die Art des Stoffes eingestellt werden.

Überraschenderweise hat sich zudem herausgestellt, dass diese Materialien in dem Fall das sie zur n-Dotierung von Elektronentransportschichten herangezogen werden, zu einer Blockierung der Elektronenleitfähigkeit der Schicht und nicht zu einer Erhöhung der Elektronenleitfähigkeit, wie im Stand der Technik beschrieben, führen.

Im Sinne der vorliegenden Erfindung bedeutet und/oder umfasst die Bezeichnung "organisches elektronisches Bauteil" insbesondere organische Transistoren, organische lichtemittierende Dioden, lichtemittierende elektrochemische Zellen, organische Solarzellen, Photodioden sowie organische Photovoltaik allgemein.

Im Sinne der vorliegenden Erfindung umfasst oder bedeutet die Bezeichnung "p-Dotand" insbesondere Materialien, die eine Lewis-Acidität aufweisen und /oder in der Lage sind, Komplexe mit dem Matrixmaterial auszubilden, in denen diese Materialien (wenn auch nur formal) Lewis-acide wirken.

Ein derartiges Metallkomplex-Matrixmaterial (Lochleiter) kann z.B. die folgende Struktur haben (s. hierzu auch Beispiel I):

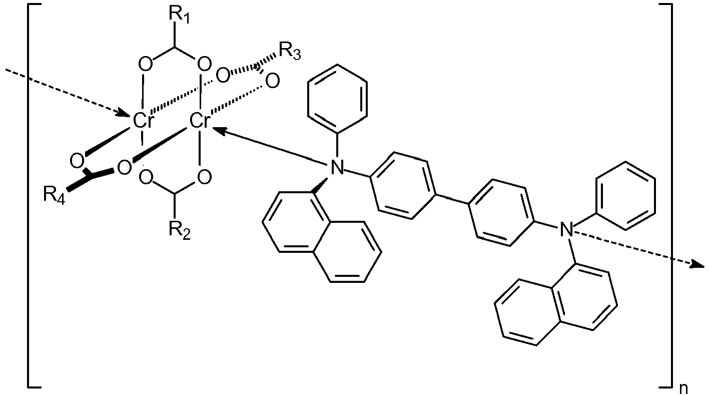

Unter dem Begriff "V b/ VI b / VII b bzw. Gruppe 5-7 Metall" werden die Metalle der 5. bis 7. Gruppe lt. IUPAC (nach der alten Bezeichnung Gruppe V b / VI b / VII b), d.h. Vanadium, Niob, Tantal (Gruppe 5), Chrom, Molybdän, Wolfram (Gruppe 6), Mangan, Technetium, Rhenium (Gruppe 7) oder Mischungen daraus verstanden. Bevorzugt sind die Metalle der Gruppe 6, d.h. Chrom, Molybdän, Wolfram, besonders bevorzugt Chrom und Molybdän.

Unter dem Begriff "bi- oder polynuclear" wird insbesondere verstanden, dass der Komplex mehr als eines der oben angegebenen Metalle enthält. Bevorzugt liegt dabei eine Wechselwirkung zwischen den Metallatomen in Form einer Metall-Metall-Wechselwirkung, bzw. einer Metall-Metall-Einfach- oder einer Metall-Metall-Mehrfach-Bindung vor.

Allgemeine Gruppendefinition: Innerhalb der Beschreibung und den Ansprüchen werden allgemeine Gruppen, wie z.B: Alkyl, Alkoxy, Aryl etc. beansprucht und beschrieben. Wenn nicht anders beschrieben, werden bevorzugt die folgenden Gruppen innerhalb der allgemein beschriebenen Gruppen im Rahmen der vorliegenden Erfindung verwendet:
alkyl: lineare und verzweigte C1-C8-Alkyle,
langkettige Alkyle: lineare und verzweigte C5-C20 Alkyle
Alkenyl: C2-C6-alkenyl,
Cycloalkyl: C3-C8-cycloalkyl,
Alkoxy: C1-C6-alkoxy,
langkettig Alkoxy: lineare und verzweigte C5-C20 Alkoxy
Alkylene: ausgewählt aus der Gruppe enthaltend: methylene; 1,1-ethylene; 1,2-ethylene; 1,1-propylidene; 1,2-propylene; 1,3- propylene; 2,2-propylidene; butan-2-ol-1,4-diyl; propan-2-ol-1,3-diyl; 1, 4-butylene; cyclohexane-1,1-diyl; cyclohexan-1,2-diyl; cyclohexan-1,3- diyl; cyclohexan-1,4-diyl; cyclopentane-1,1-diyl; cyclopentan-1,2-diyl; und cyclopentan-1,3-diyl,
Aryl: ausgewählt aus Aromaten mit einem Molekulargewicht unter 300Da.
Arylene: ausgewählt aus der Gruppe enthaltend: 1,2-phenylene; 1,3- phenylene; 1,4-phenylene; 1,2-naphthylene; 1,3-naphtalenylene; 1,4- naphthylene; 2,3-naphthylene; 1-hydroxy-2,3-phenylene; 1-hydroxy-2,4- phenylene; 1-hydroxy-2,5- phenylene; und 1-hydroxy-2,6-phenylene,
Heteroaryl: ausgewählt aus der Gruppe enthaltend: pyridinyl; pyrimidinyl; pyrazinyl; triazolyl; pyridazinyl; 1,3,5-triazinyl; chinoninyl; isochinoninyl; chinoxalinyl; imidazolyl; pyrazolyl; benzimidazolyl; thiazolyl; oxazolidinyl; pyrrolyl; thiophenyl; carbazolyl; indolyl; und isoindolyl, wobei das Heteroaryl mit der Verbindung über jedes Atom im Ring des ausgewählten Heteroaryls verbunden sein kann.
Heteroarylene: ausgewählt aus der Gruppe enthaltend: pyridindiyl; quinolindiyl; pyrazodiyl; pyrazoldiyl; triazolediyl; pyrazindiyl, thiophendiyl; und imidazolediyl, wobei das Heteroarylene als Brücke in der Verbindung über ein beliebiges Atom im Ring des ausgewählten Heteroaryls fungiert, speziell bevorzugt sind: pyridin-2, 3-diyl; pyridin-2,4-diyl; pyridin-2,5-diyl; pyridin-2,6-diyl; pyridin-3,4- diyl; pyridin-3,5-diyl; quinolin-2,3-diyl; quinolin-2,4-diyl; quinolin-2, 8-diyl; isoquinolin-1,3-diyl; isoquinolin-1,4-diyl; pyrazol-1,3-diyl; pyrazol-3,5- diyl; triazole-3,5-diyl; triazole-1,3-diyl; pyrazin-2,5-diyl; und imidazole-2,4-diyl, thiophen-2,5-diyl, thiophen-3,5-diyl; ein -C1-C6-heterocycloalkyl, ausgewählt aus der Gruppe enthaltend: piperidinyl; piperidine; 1,4-piperazine, tetrahydrothiophene; tetrahydrofuran; 1,4,7-triazacyclononane; 1,4,8,11- tetraazacyclotetradecane; 1,4,7,10,13-pentaazacyclopentadecane; 1,4-diaza- 7-thiacyclononane; 1,4- diaza-7-oxa-cyclononane; 1,4,7,10-tetraazacyclododecane; 1,4-dioxane; 1,4, 7-trithiacyclononane; pyrrolidine; und tetrahydropyran, wobei das Heteroaryl mit dem C1-C6-Alkyl über jedes Atom im Ring des ausgewählten Heteroaryls verbunden sein kann.
Heterocycloalkylene: ausgewählt aus der Gruppe enthaltend: piperidin-1,2- ylene; piperidin-2,6-ylene; piperidin-4,4-ylidene; 1,4-piperazin-1,4-ylene; 1,4-piperazin-2,3-ylene; 1,4-piperazin-2,5-ylene; 1,4-piperazin-2,6-ylene; 1,4-piperazin- 1,2-ylene; 1,4-piperazin-1,3-ylene; 1,4-piperazin-1,4-ylene; tetrahydrothiophen-2,5-ylene; tetrahydrothiophen-3,4-ylene; tetrahydrothiophen-2,3-ylene; tetrahydrofuran-2,5-ylene; tetrahydrofuran- 3,4-ylene; tetrahydrofuran-2,3-ylene; pyrrolidin-2,5-ylene; pyrrolidin-3,4-ylene; pyrrolidin-2,3-ylene; pyrrolidin-1,2-ylene; pyrrolidin-1,3-ylene; pyrrolidin-2,2-ylidene; 1,4,7-triazacyclonon-1,4-ylene; 1,4,7- triazacyclonon-2,3-ylene; 1,4,7-triazacyclonon-2,9-ylene; 1,4,7-triazacyclonon-3,8-ylene; 1,4,7-triazacyclonon-2,2- ylidene; 1,4,8,11-tetraazacyclotetradec-1,4-ylene; 1,4,8,11- tetraazacyclotetradec-1,8-ylene; 1,4,8,11-tetraazacyclotetradec-2,3-ylene; 1,4,8,11-tetraazacyclotetradec-2,5-ylene; 1,4,8,11-tetraazacyclotetradec-1,2-ylene; 1,4,8,11- tetraazacyclotetradec-2,2-ylidene; 1,4,7,10-tetraazacyclododec-1,4-ylene; 1,4,7,10-tetraazacyclododec-1,7-ylene; 1,4,7,10-tetraazacyclododec-1,2- ylene; 1,4,7,10-tetraazacyclododec-2,3- ylene; 1,4,7,10-tetraazacyclododec-2,2-ylidene; 1,4,7,10,13 pentaazacyclopentadec-1,4-ylene; 1,4,7,10,13-pentaazacyclopentadec-1,7-ylene; 1,4,7,10,13-pentaazacyclopentadec-2,3- ylene; 1,4,7,10,13-pentaazacyclopentadec-1,2-ylene; 1,4,7,10, 13-pentaazacyclopentadec-2,2-ylidene; 1,4-diaza-7-thia-cyclonon-1,4-ylene; 1,4-diaza-7-thia-cyclonon-1,2-ylene; 1,4-diaza-7thia-cyclonon- 2,3-ylene; l,4-diaza-7-thia-cyclonon-6,8-ylene; 1,4-diaza-7-thia-cyclonon- 2,2-ylidene; 1,4-diaza-7-oxacyclonon-1,4-ylene; 1,4-diaza-7-oxa-cyclonon- 1,2-ylene; 1,4diaza-7-oxa-cyclonon-2,3-ylene; 1,4-diaza-7-oxa-cyclonon-6, 8-ylene; 1,4-diaza-7-oxa-cyclonon-2,2-ylidene; 1,4-dioxan-2,3-ylene; 1,4- dioxan-2,6-ylene; 1,4-dioxan-2,2-ylidene; tetrahydropyran-2,3-ylene; tetrahydropyran-2,6-ylene; tetrahydropyran-2,5-ylene; tetrahydropyran-2,2- ylidene; 1,4,7-trithia-cyclonon-2,3-ylene; 1,4,7-trithia-cyclonon-2,9- ylene; und 1,4,7-trithia-cyclonon-2,2-ylidene,
Heterocycloalkyl: ausgewählt aus der Gruppe enthaltend: pyrrolinyl; pyrrolidinyl; morpholinyl; piperidinyl; piperazinyl; hexamethylene imine; 1,4-piperazinyl; tetrahydrothiophenyl; tetrahydrofuranyl; 1,4,7- triazacyclononanyl; 1,4,8,11-tetraazacyclotetradecanyl; 1,4,7,10,13- pentaazacyclopentadecanyl; 1,4-diaza-7-thiacyclononanyl; 1,4-diaza-7-oxa-cyclononanyl; 1,4,7,10-tetraazacyclododecanyl; 1,4-dioxanyl; 1,4,7- trithiacyclononanyl; tetrahydropyranyl; und oxazolidinyl, wobei das Heterocycloalkyl mit der Verbindung über jedes Atom im Ring des ausgewählten Heterocycloalkyls verbunden sein kann.
Amine: die Gruppe -N(R)2 wobei jedes R unabhängig ausgewählt ist aus: Wasserstoff; C1-C6-alkyl; C1-C6-alkyl-C6H5; und phenyl, wobei wenn beide R' C1-C6 alkyl sind, beide R' einen - NC3 bis NC5 heterocyclischen Ring bilden können, wobei die restliche Alkylkette einen Alkylsubstituenten am heterocyclischen Ring bildet
Halogen: ausgewählt aus der Gruppe enthaltend: F; Cl; Br und I
Halogenalkyl: ausgewählt aus der Gruppe enthaltend mono, di, tri-, poly und perhalogenierte lineare und verzweigte C1-C8-alkyl, insbesondere -CF₃.
Pseudohalogen: ausgewählt aus der Gruppe enthaltend -CN, - SCN, -OCN, N3, -CNO und -SeCN.
Carboxylat: die Gruppe -C(0)0R, wobei R ausgewählt ist aus: Wasserstoff; C1-C6-alkyl; phenyl; C1-C6-alkyl-C6H5;
Carbonyl: die Gruppe -C(O)R, wobei R ausgewählt ist aus: Wasserstoff; C1-C6-alkyl; phenyl; C1-C6-alkyl-C6H5 und amine ausgewählt aus der Gruppe: -NR'2, wobei jedes R' unabhängig ausgewählt ist aus: Wasserstoff; C1- C6-alkyl; C1-C6-alkyl-C6H5; und phenyl, wobei wenn beide R' C1-C6 alkyl sind, beide R' einen -NC3 bis NC5 heterocyclischen Ring bilden können, wobei die restliche Alkylkette einen Alkylsubstituenten am heterocyclischen Ring bildet.

Soweit nicht anders erwähnt, sind die folgenden Gruppen mehr bevorzugte Gruppen innerhalb der allgemeinen Gruppendefinition:
alkyl: lineare und verzweigte C1-C6-alkyl,
langkettige Alkyle: lineare und verzweigte C5-C10 alkyl, vorzugsweise C6-C8 alkyle
alkenyl: C3-C6-alkenyl,
cycloalkyl: C6-C8-cycloalkyl,
alkoxy: C1-C4-alkoxy,
langkettig Alkoxy: lineare und verzweigte C5-C10 alkoxy, vorzugsweise lineare C6-C8 alkoxy
Alkylene: ausgewählt aus der Gruppe enthaltend: methylene; 1,2-ethylene; 1,3-propylene; butan-2-ol-1,4-diyl; 1,4-butylene; cyclohexane-1,1-diyl; cyclohexan-1,2-diyl; cyclohexan-1,4-diyl; cyclopentane-1,1-diyl; und cyclopentan-1,2-diyl,
Aryl: ausgewählt aus der Gruppe enthaltend: phenyl; biphenyl; naphthalenyl; anthracenyl; und phenanthrenyl,
arylene: ausgewählt aus der Gruppe enthaltend: 1,2-phenylene; 1,3- phenylene; 1,4-phenylene; 1,2-naphthylene; 1,4-naphtalenylene; 2,3- naphthylene und 1-hydroxy-2,6-phenylene,
Heteroaryl: ausgewählt aus der Gruppe enthaltend: pyridinyl; pyrimidinyl; chinoninyl; pyrazolyl; triazolyl; isochinoninyl; imidazolyl; und oxazolidinyl, wobei das Heteroaryl mit der Verbindung über jedes Atom im Ring des ausgewählten Heteroaryls verbunden sein kann,
Heteroarylene: ausgewählt aus der Gruppe enthaltend: pyridin 2,3-diyl; pyridin-2,4-diyl; pyridin-2,6-diyl; pyridin-3,5-diyl; quinolin-2,3-diyl; quinolin-2,4-diyl; isoquinolin-1,3-diyl; isoquinolin-1,4-diyl; pyrazol-3,5-diyl; und imidazole-2,4-diyl,
Heterocycloalkyl: ausgewählt aus der Gruppe enthaltend: pyrrolidinyl; morpholinyl; piperidinyl; piperidinyl; 1,4 piperazinyl; tetrahydrofuranyl; 1,4,7-triazacyclononanyl; 1,4,8,11-tetraazacyclotetradecanyl; 1,4,7,10,13- pentaazacyclopentadecanyl; 1,4,7,10-tetraazacyclododecanyl; und piperazinyl, wobei das Heteroaryl mit der Verbindung über jedes Atom im Ring des ausgewählten Heteroaryls verbunden sein kann,
Heterocycloalkylene: ausgewählt aus der Gruppe enthaltend: piperidin-2,6-ylene; piperidin-4,4-ylidene; 1,4-piperazin-1,4-ylene; 1,4-piperazin-2,3-ylene; 1,4-piperazin-2,6-ylene; tetrahydrothiophen-2,5-ylene; tetrahydrothiophen-3,4-ylene; tetrahydrofuran-2,5-ylene; tetrahydrofuran-3,4-ylene; pyrrolidin-2,5-ylene; pyrrolidin-2,2-ylidene; 1,4,7-triazacyclonon-1,4- ylene; 1,4,7-triazacyclonon-2,3-ylene; 1,4,7-triazacyclonon-2,2-ylidene; 1,4,8,11- tetraazacyclotetradec-1,4-ylene; 1,4,8,11- tetraazacyclotetradec-1,8-ylene; 1,4,8,11-tetraazacyclotetradec-2,3-ylene; 1,4,8,11-tetraazacyclotetradec-2,2-ylidene; 1,4,7,10-tetraazacyclododec-1,4-ylene; 1,4,7,10- tetraazacyclododec-1,7-ylene; 1,4,7,10-tetraazacyclododec-2,3-ylene; 1,4,7,10-tetraazacyclododec-2,2-ylidene; 1,4,7,10,13- pentaazacyclopentadec-1,4-ylene; 1,4,7,10,13- pentaazacyclopentadec-1,7-ylene; 1,4-diaza-7-thia-cyclonon-1,4 ylene; 1,4-diaza-7-thiacyclonon-2,3-ylene; 1,4-diaza-7-thiein cyclonon-2,2-ylidene; 1,4-diaza-7-oxa-cyclonon-1,4-ylene; 1,4 diaza-7-oxa-cyclonon-2,3-ylene;1,4-diaza-7-oxa-cyclonon-2,2- ylidene; 1,4-dioxan-2,6-ylene; 1,4-dioxan-2,2-ylidene; tetrahydropyran-2,6-ylene; tetrahydropyran-2,5-ylene; und tetrahydropyran- 2,2-ylidene, ein -C1-C6-alkyl-heterocycloalkyl, wobei das Heterocycloalkyl ausgewählt aus der Gruppe enthaltend: piperidinyl; 1,4-piperazinyl; tetrahydrofuranyl; 1,4,7- triazacyclononanyl; 1,4,8,11-tetraazacyclotetradecanyl; 1,4,7,10,13- pentaazacyclopentadecanyl; 1,4,7,10-tetraazacyclododecanyl; und pyrrolidinyl, wobei das Heterocycloalkyll mit der Verbindung über jedes Atom im Ring des ausgewählten Heterocycloalkyls verbunden sein kann,
Amin: die Gruppe -N (R) 2, wobei jedes R unabhängig ausgewählt ist aus: Wasserstoff; C1-C6-alkyl; und benzyl, Halogen: ausgewählt aus der Gruppe enthaltend: F und Cl,
Carboxylat: die Gruppe -C(O)OR, wobei R ausgewählt ist aus Wasserstoff; C1-C6-alkyl; und benzyl,
Carbonyl: die Gruppe: -C(O)R, wobei R ausgewählt ist aus: Wasserstoff; C1-C6-alkyl; benzyl und amine ausgewählt aus der Gruppe: -NR'2, wobei jedes R' unabhängig ausgewählt ist aus: Wasserstoff; C1-C6-alkyl; und benzyl,

Gemäß einer bevorzugten Ausführungsform ist R³ Halogenalkyl, besonders bevorzugt Perfluoralkyl mit 1 bis 8 Kohlenstoffen, noch bevorzugter 1 bis 4, Halogenaryl, besonders bevorzugt Perfluoraryl, Halogenalkylaryl, besonders bevorzugt (Per)fluoralkylaryl und Halogenheteroaryl, besonders bevorzugt Perfluorheteroaryl.

Desweiteren seien beispielhaft als Liganden L bevorzugt angeführt fluorierte oder nicht-fluorierte Benzoesäuren wie z.B. 2-(Trifluoromethyl)benzoesäure; 3,5-Difluorobenzoesäure; 3-Hydroxy-2,4,6-triiodobenzoesäure; 3-Fluoro-4-methylbenzoesäure; 3-(Trifluoromethoxy)benzoesäure; 4-(Trifluoromethoxy)benzoesäure; 4-Chloro-2,5-difluorobenzoesäure; 2-Chloro-4,5-difluorobenzoesäure; 2,4,5-Trifluorobenzoesäure; 2-Fluorobenzoesäure; 4-Fluorobenzoesäure; 2,3,4-Trifluorobenzoesäure; 2,3,5-Trifluorobenzoesäure; 2,3-Difluorobenzoesäure; 2,4-Bis(trifluoromethyl)benzoesäure; 2,4-Difluorobenzoesäure; 2,5-Difluorobenzoesäure; 2,6-Bis(trifluoromethyl)benzoesäure; 2,6-Difluorobenzoesäure; 2-Chloro-6-fluorobenzoesäure; 2-Fluoro-4-(trifluoromethyl)benzoesäure; 2-Fluoro-5-(trifluoromethyl)benzoesäure; 2-Fluoro-6-(trifluoromethyl)benzoesäure; 3,4,5-Trifluorobenzoesäure; 3,4-Difluorobenzoesäure; 3,5-Bis(trifluoromethyl)benzoesäure; 3-(Trifluoromethyl)benzoesäure; 3-Chloro-4-fluorobenzoesäure; 3-Fluoro-5-(trifluoromethyl)benzoesäure; 3-Fluorobenzoesäure; 4-Fluoro-2-(trifluoromethyl)benzoesäure; 4-Fluoro-3-(trifluoromethyl)benzoesäure; 5-Fluoro-2-methylbenzoesäure; 2-(Trifluoromethoxy)benzoesäure; 2,3,5-Trichlorobenzoesäure; 4-(Trifluoromethyl)benzoesäure; Pentafluorobenzoesäure; 2,3,4,5-Tetrafluorobenzoesäure,
fluorierte oder nicht-fluorierte Phenylessigsäure wie z.B. 2-Fluor-Phenylessigsäure; 3-Fluor-Phenylessigsäure; 4-Fluor-Phenylessigsäure; 2,3-Difluor-Phenylessigsäure; 2,4-Difluor-Phenylessigsäure; 2,6-Difluor-Phenylessigsäure; 3,4-Difluor-Phenylessigsäure; 3,5-Difluor-Phenylessigsäure; Pentafluor-Phenylessigsäure; 2-Chloro-6-fluor-Phenylessigsäure; 2-Chloro-3,6-difluor-Phenylessigsäure; 3-Chloro-2,6-difluor-Phenylessigsäure; 3-Chloro-4-fluor-Phenylessigsäure; 5-Chloro-2-fluor-Phenylessigsäure; 2,3,4-Trifluor-Phenylessigsäure; 2,3,5-Trifluor-Phenylessigsäure; 2,3,6-Trifluor-Phenylessigsäure; 2,4,5-Trifluor-Phenylessigsäure; 2,4,6-Trifluor-Phenylessigsäure; 3,4,5-Trifluor-Phenylessigsäure; 3-Chloro-2-fluor-Phenylessigsäure; α-Fluor-Phenylessigsäure; 4-Chloro-2-fluor-Phenylessigsäure; 2-Chloro-4-fluor-Phenylessigsäure; α,α-Difluor-Phenylessigsäure; Ethyl 2,2-Difluor-2-phenylacetate; und
fluorierte oder nicht-fluorierte Essigsäure wie z.B. Methyltrifluoroacetat; Allyl-trifluoroacetat; Ethyltrifluoroacetat; Isopropyl-trifluoroacetat; 2,2,2-Trifluoroethyl-trifluoroacetat; Difluoroessigsäure; Trifluoroessigsäure; Methyl-chlorodifluoroacetat; Ethylbromodifluoroacetat; Chlorodifluoroessigsäure; Ethylchlorofluoroacetat; Ethyl-difluoroacetat; (3-Chlorophenyl)-difluoroessigsäure; (3,5-Difluorophenyl)-difluoroessigsäure; (4-Butylphenyl)difluoroessigsäure; (4-tert-Butylphenyl)difluoroessigsäure; (3,4-Dimethylphenyl)-difluoroessigsäure; (3-Chloro-4-fluorophenyl)-difluoroessigsäure; (4-Chlorophenyl)-difluoroessigsäure; 2-Biphenyl-3',5'-difluoroessigsäure; 3-Biphenyl-3',5'-difluoroessigsäure; 4-Biphenyl-3',5'-difluoroessigsäure; 2-Biphenyl-3',4'-difluoroessigsäure; 3-Biphenyl-3',4'-difluoroessigsäure; 4-Biphenyl-3',4'-difluoroessigsäure; 2,2-Difluoro-propionsäure bzw. deren höheren Homologen. Falls die Liganden L saure Gruppen aufweisen; können die Gruppen in einer bevorzugten Ausführungsform deprotoniert vorliegen.

Gemäß einer alternativen bevorzugten Ausführungsform ist R³ ausgewählt aus der Gruppe enthaltend: 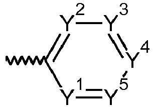 wobei Y¹ - Y⁵ unabhängig voneinander ausgewählt sind aus der Gruppe enthaltend C-F, C-CF₃ C-NO₂, C-CN, C-Halogen, C-Pseudohalogen oder N.

Gemäß einer bevorzugten Ausführungsform ist R³ ausgewählt aus der Gruppe enthaltend: 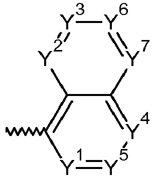 wobei Y¹ - Y⁷ unabhängig voneinander ausgewählt sind aus der Gruppe enthaltend C-F, C-CF₃, C-NO₂, C-CN, C-Halogen, C-Pseudohalogen oder N.

Gemäß einer bevorzugten Ausführungsform ist R³ ausgewählt aus der Gruppe enthaltend: 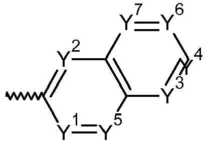 wobei Y¹ - Y⁷ unabhängig voneinander ausgewählt sind aus der Gruppe enthaltend C-F,CF₃, C-NO₂, C-CN, C-Halogen, C-Pseudohalogen oder N.

Gemäß einer bevorzugten Ausführungsform ist R³ ausgewählt aus der Gruppe enthaltend:

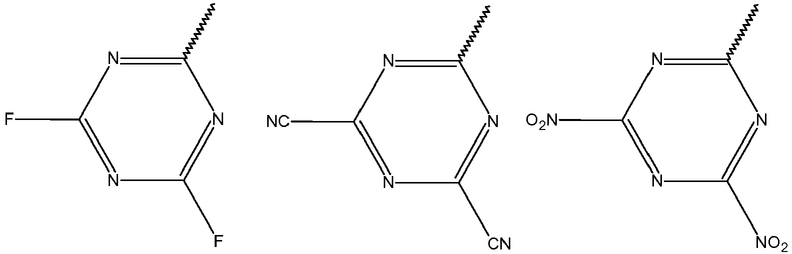

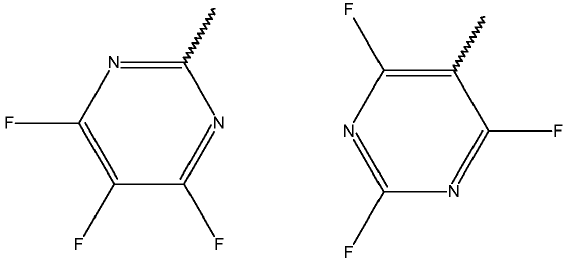

Gemäß einer bevorzugten Ausführungsform ist R³ ausgewählt aus der Gruppe enthaltend halogenierte, bevorzugt perhalogenierte und/oder pseudohalogenierte Pteridine, Isopteridine, Naphtyridine, Chinoxaline, Azachinoxaline.

In einer weiteren bevorzugten Ausführungsform kann der Metallkomplex mindestens einen Liganden L ausgewählt aus der Gruppe der nicht substituierten, partiell fluorierten oder per-fluorierten organischen Carbonsäuren enthalten. Organische Carbonsäuren können generell ausgewählt werden aus den Gruppen der aliphatisch, gesättigten Monocarbonsäuren; aliphatisch, ungesättigten Monocarbonsäuren; aliphatisch, gesättigten Dicarbonsäuren; aliphatisch, gesättigten Tricarbonsäuren; aliphatisch, ungesättigten Dicarbonsäuren; aromatischen Carbonsäuren; heterocyclischen Carbonsäuren; aliphatisch, ungesättigten, cyclischen Monocarbonsäuren. Besonders bevorzugte partielle oder perfluorierte Liganden L werden ausgewählt aus substituierten oder unsubstituierten Verbindungen der Essigsäure, Phenylessigsäure und/oder Benzoesäure und sind beispielhaft oben angeführt. Besonders bevorzugt ist nicht-fluorierte, partiell fluorierte oder perfluorierte Essigsäure.

Gemäß einer bevorzugten Ausführungsform ist mindestens einer der Liganden L zwischen zwei Metallen verbrückend angeordnet.

Gemäß einer bevorzugten Ausführungsform ist der Metallkomplex (ohne Anwesenheit von Matrixmaterial) lewis-sauer, d.h. er agiert gegenüber dem als Matrixmaterial wirkenden Lochleiter als Elektronenpaarakzeptor. Dies hat sich für eine Interaktion mit den Matrixmaterialien als besonders bevorzugt herausgestellt.

Gemäß einer bevorzugten Ausführungsform besitzt der Metallkomplex (ohne Anwesenheit von Matrixmaterial) mindestens eine offene oder teilweise zugängliche Koordinationsstelle. Dies hat sich ebenfalls für eine Interaktion mit den Matrixmaterialien als besonders bevorzugt herausgestellt.

Gemäß einer bevorzugten Ausführungsform besitzt der Metallkomplex die Summenformel M₂Lₙ, (mit M= Metall und L= Ligand sowie n=3 oder 4), wobei sowohl die Metalle wie die einzelnen Liganden unabhängig voneinander gemäß der obigen Definition ausgewählt sein können.

In Metallkomplexen dieser Struktur findet sich eine M=M Mehrfachbindung, die sich als besonders günstig für die elektrischen und optischen Eigenschaften herausgestellt hat. Bestimmte Metallkomplexe dieses Typs bezeichnet man auch als "Schaufelrad" ("paddle wheel")- Komplexe, diese sind insbesondere bevorzugt.

Gemäß einer weiteren bevorzugten Ausführungsform sind in der Gruppe der Molybdän enthaltenden Metallkomplexe besonders bevorzugt Molybdän-Paddlewheel-Metallkomplexe mit Sauerstoff/Sauerstoff, Sauerstoff/Stickstoff oder Stickstoff/Stickstoff verbrückenden Liganden. Desweiteren bevorzugt in der Gruppe der Molybdän-Komplexe können zweikernige Molybdän-Komplexe Mo₂⁴⁺ mit einer nicht-Paddle-Wheel-Struktur, aber mit Metall-Metall-Wechselwirkungen eingesetzt werden. Weitere bevorzugte Liganden für die zweikernigen Molybdän-Komplexe Mo₂⁴⁺ mit einer nicht-Paddle-Wheel-Struktur können zusätzlich zu den oben aufgeführten Liganden besonders bevorzugt ausgewählt werden aus der Gruppe der Halogene, Wasser, Wasserstoff, Alkoxide, mehrzähnige, chelatierende Liganden oder Mischungen dieser Liganden.

In einer weiteren bevorzugten Ausführungsform kann der Metallkomplex eine zweikernige Schaufelradstruktur aufweisen, Chrom oder Molybdän enthalten und R¹ und R² aus Sauerstoff bestehen. Metallkomplexe mit Schaufelradstruktur sind in der Literatur bekannt und zum Beispiel in Cotton et al. "Multiple Bonds between Metal Atoms", Third Edition, 2005, ISBN 0-387-22605-2, beschrieben. Eine bevorzugte erfindungsgemäße Schaufelradstruktur ("paddle wheel") ist beispielhaft in folgender Abbildung gezeigt:

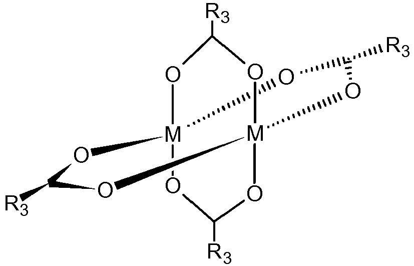

Gemäß einer bevorzugten Ausführungsform umfasst das Matrixmaterial des organischen elektronischen Bauteils eines oder mehrere der folgenden Materialien:
NPB (N,N'-Bis(naphthalen-1-yl)-N,N'-bis(phenyl)-benzidin), β-NPB N,N'-Bis(naphthalen-2-yl)-N,N'-bis(phenyl)-benzidin) TPD (N,N'-Bis(3-methylphenyl)-N,N'-bis(phenyl)-benzidin) Spiro TPD (N,N'-Bis(3-methylphenyl)-N,N'-bis(phenyl)-benzidin)
Spiro-NPB (N,N'-Bis(naphthalen-1-yl)-N,N'-bis(phenyl)-spiro) DMFL-TPD N,N'-Bis(3-methylphenyl)-N,N'-bis(phenyl)-9,9-dimethyl-fluoren)
DMFL-NPB (N,N'-Bis(naphthalen-1-yl)-N,N'-bis(phenyl)-9,9-dimethyl-fluoren)
DPFL-TPD (N,N'-Bis(3-methylphenyl)-N,N'-bis(phenyl)-9,9-diphenyl-fluoren)
DPFL-NPB (N,N'-Bis(naphthalen-1-yl)-N,N'-bis(phenyl)-9,9-diphenyl-fluoren)
Spiro-TAD (2,2',7,7'-Tetrakis(n,n-diphenylamino)-9,9'-spirobifluoren)
9,9-Bis[4-(N,N-bis-biphenyl-4-yl-amino)phenyl]-9H-fluoren 9,9-Bis[4-(N,N-bis-naphthalen-2-yl-amino)phenyl]-9H-fluoren 9,9-Bis[4-(N,N'-bis-naphthalen-2-yl-N,N'-bis-phenyl-amino)-phenyl]-9H-fluoren
N,N'-bis(phenanthren-9-yl)-N,N'-bis(phenyl)-benzidin 2,7-Bis[N,N-bis(9,9-spiro-bifluorene-2-yl)-amino]-9,9-spiro-bifluoren
2,2'-Bis[N,N-bis(biphenyl-4-yl)amino]9,9-spiro-bifluoren 2,2'-Bis(N,N-di-phenyl-amino)9,9-spiro-bifluoren Di-[4-(N,N-ditolyl-amino)-phenyl]cyclohexan
2,2',7,7'-tetra(N, N-di-tolyl)amino-spiro-bifluoren N, N,N',N'-tetra-naphthalen-2-yl-benzidin

Diese Materialien haben sich als lochleitende Matrixmaterialien in organischen elektronischen Bauteilen bewährt.

Gemäß einer bevorzugten Ausführungsform der Erfindung beträgt der Dotierungsgrad in mol Metallkomplex bezogen auf mol Matrixmaterial von ≥0,1% bis ≤50%. Dies hat sich als zweckmäßig herausgestellt. Bevorzugt beträgt der Dotierungsgrad von ≥0,5% bis ≤15%, noch bevorzugt ≥1% bis ≤5%.

Des Weiteren wird offenbart, dass die Verwendung eines bi-oder polynuclearen Gruppe V b/ VI b / VII b bzw. Gruppe 5-7 Austauschseite

Metallkomplexes, enthaltend mindestens einen Liganden L der folgenden Struktur: 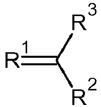
wobei R¹ und R² unabhängig voneinander Sauerstoff, Schwefel, Selen, NH oder NR⁴ sein können, wobei R⁴ ausgewählt ist aus der Gruppe enthaltend Alkyl oder Aryl und mit R³ verbunden sein kann; und
R³ ausgewählt ist aus der Gruppe enthaltend Alkyl, langkettiges Alkyl, Alkoxy, langkettiges Alkoxy, Cycloalkyl, Halogenalkyl, Aryl, Arylene, Halogenaryl, Heteroaryl, Heteroarylene, Heterocycloalkylene, Heterocycloalkyl, Halogenheteroaryl, Alkenyl, Halogenalkenyl, Alkinyl, Halogenalkinyl, Ketoaryl, Halogenketoaryl, Ketoheteroaryl, Ketoalkyl, Halogenketoalkyl, Ketoalkenyl, Halogenketoalkenyl, wobei bei geeigneten Resten eine oder mehrere nicht-benachbarte CH₂-Gruppen unabhängig voneinander durch -O-, -S-, -NH-, -CO-, -COO-,-OCO-, -OCO-O-, -SO₂-, -S-CO-, -CO-S-, -CY1=CY₂ oder -C=C- ersetzt sein können und zwar derart, dass 0 und/oder S Atome nicht direkt miteinander verbunden sind, ebenfalls optional mit Aryl- oder Heteroaryl bevorzugt enthaltend 1 bis 30 C Atome ersetzt sind (endständige CH₃-Gruppen werden wie CH₂-Gruppen im Sinne von CH₂-H verstanden).
als p-Dotierungsmittel für Matrixmaterialien elektronischer Bauteile möglich ist.

Die vorgenannten sowie die beanspruchten und in den Ausführungsbeispielen beschriebenen erfindungsgemäß zu verwendenden Bauteile unterliegen in ihrer Größe, Formgestaltung, Materialauswahl und technischen Konzeption keinen besonderen Ausnahmebedingungen, so dass die in dem Anwendungsgebiet bekannten Auswahlkriterien uneingeschränkt Anwendung finden können.

### Austauschseite

Weitere Einzelheiten, Merkmale und Vorteile des Gegenstandes der Erfindung ergeben sich aus den Unteransprüchen sowie aus der nachfolgenden Beschreibung der Figuren und der zugehörigen Beispiele. In den Figuren zeigt:
Fig. 1 schematisch den Aufbau einer organischen Leuchtdiode (10). Die Leuchtdiode ist aufgebaut aus einer Glas-Schicht (1); Transparent Conductive oxide (TCO)- oder PEDOT:PPS- oder PANI-Schicht (2); Loch-Injektor-Schicht (3); Loch-Transportschicht (HTL) (4); Emitter-Schicht (EML) (5); Loch-Blocker-Schicht (HBL) (6); Elektronen-Transportschicht (ETL) (7); Elektronen-Injektorschicht (8)und einer Kathoden-Schicht (9) ;
Fig. 2 schematisch den Aufbau einer organischen Solarzelle mit PIN-Struktur (20), welche Licht (21) in elektrischen Strom umwandelt. Die Solarzelle besteht aus einer Schicht aus Indium-Zinn-Oxid (22); einer p-dotierten Schicht(23); einer Absorptions-Schicht (24); einer n-dotierten Schicht (25) und einer Metall-Schicht (26);
Fig. 3 schematisch einen möglichen Querschnitt eines organischen Feld-Effekt-Transistors (30). Auf einem Substrat (31) ist eine Gate-Elektrode (32), ein Gate-Dielektrikum (33), ein Source and Drain-Kontakt (34 + 35) und ein organischer Halbleiter (36) aufgebracht. Die schraffierten Stellen zeigen die Stellen an denen eine Kontaktdotierung hilfreich ist.
Fig. 4 die Stromdichte gegen die Spannung für ein undotiertes Matrixmaterial sowie für mehrere dotierte Matrixmaterialien gemäß einer ersten Ausführungsform der Erfindung;
Fig. 5 die Absorption gegen die Wellenlänge für die Materialien aus Fig. 4;
Fig. 6 die Reflektion gegen die Wellenlänge für die dotierten Materialien aus Fig. 4
Fig. 7 die normierte Emission gegen die Wellenlänge für die dotierten Materialien aus Fig. 4
Fig. 8 die Stromdichte gegen die Spannung für ein undotiertes Matrixmaterial sowie für mehrere dotierte Matrixmaterialien gemäß einer zweiten Ausführungsform der Erfindung;
Fig. 9 die Absorption gegen die Wellenlänge für die Materialien aus Fig. 8;
Fig. 10 die Reflektion gegen die Wellenlänge für die dotierten Materialien aus Fig. 8
Fig. 11 die normierte Emission gegen die Wellenlänge für die Materialien aus Fig. 8

### Beispiel I

### Beispiel I bezieht sich auf Cr₂(O₂CCF₃)₄(Et₂O)₂, welches wie folgt hergestellt wurde

### Synthese von K₄Cr₂(CO₃)₄.

Die Vorstufe K₄Cr₂(CO₃)₄ wurde wie folgt hergestellt: Cr-Metall (2,5g; 48,1mmol) wurde in ein Schlenkgefäß, gefüllt 20mL sauerstofffreiem Wasser unter einem Argonstrom gegeben. HCl (8mL; 82,5mmol) wurde tropfenweise hinzugegeben. Die Lösung färbte sich instantan tiefblau. Anschließend wurde durch Celite gefiltert, um überschüssiges Chrom zu entfernen.

20mL einer wässrigen K₂CO₃ - Lösung (12g ; 87,0mmol), durch welche eine Stunde lang Argonstrom geblasen wurde, wurde zur blauen CrCl₂-Lösung gegeben, worauf ein orangeroter Feststoff ausfiel, welcher filtriert, dreimal mit Diethylether gewaschen und anschließend im Vakuum getrocknet wurde. Ausbeute: 94%

### Synthese von Cr₂(O₂CCF₃)₄(Et₂O)ₓ X(X<2)

K₄Cr₂(CO₃)₄ (4g; 8,0mol) und Trifluoressigsäure (3mL; 38,9mmol) wurden 6h in Diethylether im Rückfluß erhitzt. Dabei wurde nach ca. einer Stunde die orange Lösung tiefblau. Nach Filtrieren wurde das Lösemittel entfernt und bis zur Gewichtskonstanz im Vakuum getrocknet. Man erhielt ein violettes Pulver. Ausbeute: 86%
Das Produkt wurde weiter durch Sublimation gereinigt.

### Verdampfung

ITO -vorstrukturierte Glassubstrate wurden 10 min. einer Sauerstoffplasmabehandlung unterzogen und dann anschließend so schnell als möglich in den Verdampfer überführt. Der Verdampfer wurde in eine Argon-Glovebox überführt, in der die Sauerstoff- und Wasserkonzentration weniger als 2ppm beträgt.

Alle Verdampfungen wurden bei einem Vakuum von weniger als 2 x 10⁻⁶ mbar Basisdruck durchgeführt (Bei der Verdampfung steigt der Druck dann an).

Zunächst wurden sowohl Matrix- wie Dotiermaterial bis kurz vor den Verdampfungspunkt erhitzt, anschließend wurde solange erhitzt, bis eine konstante Verdampfung beobachtet werden konnte.

Die gesamte Verdampfungsrate war ungefähr 1 Ǻ/s, wobei die Verdampfungsrate des Dotiermaterials über die Verdampfungsrate des Matrixmaterials eingestellt wurde.

Nachdem die Shutter geschlossen waren, wurde auf 40°C abgekühlt, mit Argon evakuiert und die Maske für die Abscheidung der Kathode gewechselt.

Die Elektrode bestand aus einer 150nm dicken AluminiumSchicht, welche mit einer anfänglichen Verdampfungsrate von 0,5 Ǻ/s, welche langsam auf 5 Ǻ/s gesteigert wurde, aufgebracht wurde.

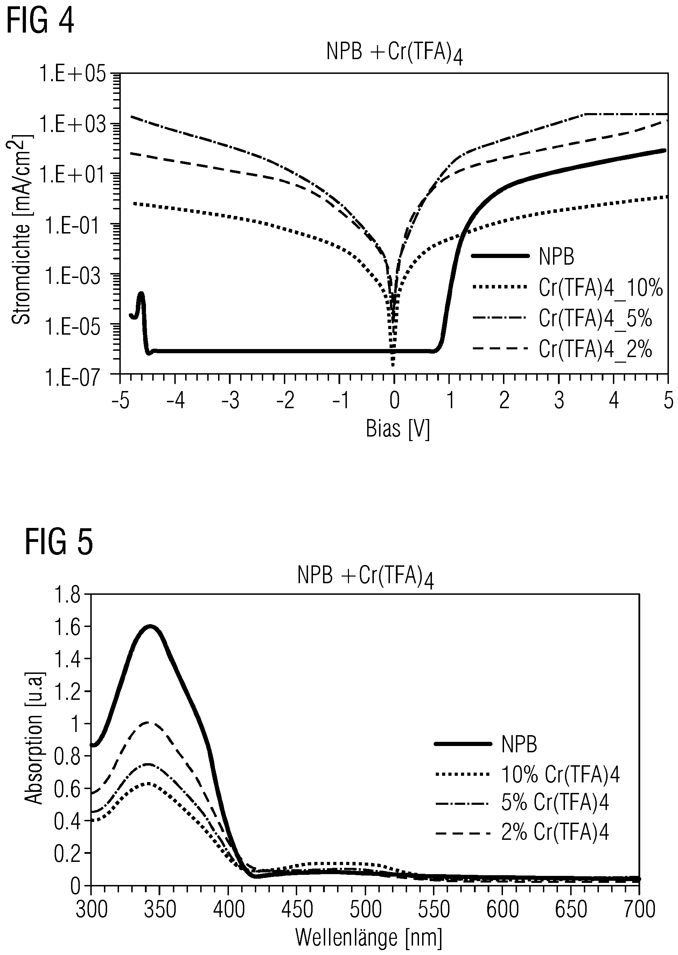

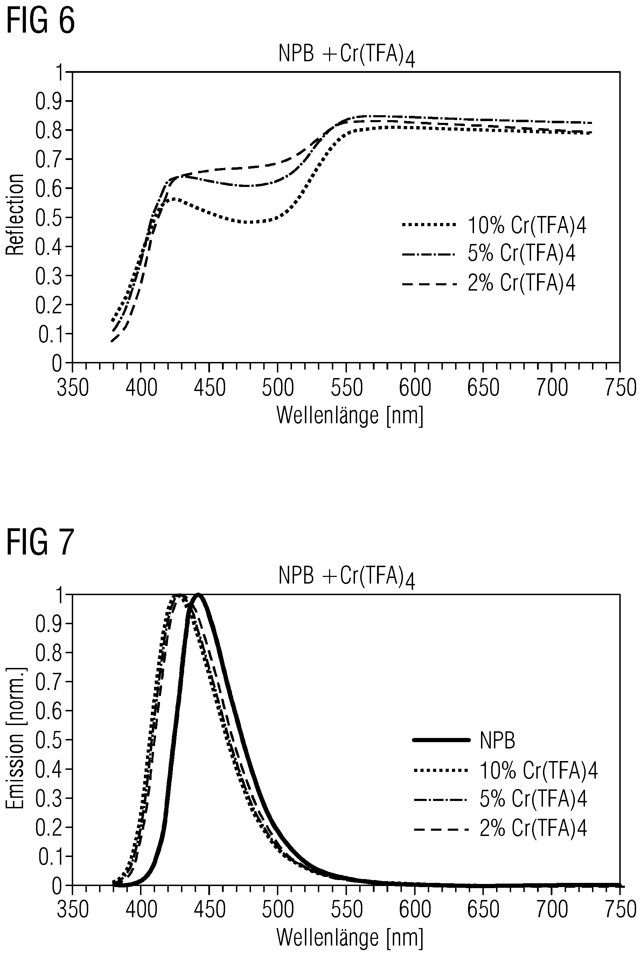

Die Figuren 4 bis 7 beziehen sich auf mit Cr₂(O₂CCF₃)₄(Et₂O)ₓ (mit x < 2) dotiertes sowie undotiertes NPB = (= Bis-N,N,N',N'-(naphthyl-phenyl)benzidine). Dabei wurden jeweils 200 nm dicke Schichten von NPB einerseits sowie mit 2% Cr2(O₂CCF₃)4(Et₂O)₄, 5% Cr₂(O₂CCF₃)₄(Et₂O)ₓ und 10% Cr₂(O2CCF₃)₄(Et₂O)ₓ dotiertes NPB andererseits hergestellt.

Fig. 4 zeigt die Stromdichte gegen die angelegte Spannung für die vier Materialien. Man sieht schon bei der 2% dotierten Schicht eine Erhöhung der Stromdichte gegen die angelegte Spannung.

Zur Untersuchung der optischen Eigenschaften des erfindungsgemäßen Dotiermaterials wurden die Absorption, die Reflektion und die normierte Emission gemessen (Figuren 4 bis 7). Man sieht, dass die Komplexe nahezu transparent sind, was sie geeignet für einen Einsatz in (opto)-elektronischen Bauteilen macht.

### Beispiel II:

Beispiel II bezieht sich auf Mo₂(O₂CCF₃)₄, welches gemäß F. A. Cotton and J.G. Norman, Jr. Coord. Chem, 1971, 1 ,161 hergestellt wurde.

In Analogie zu Beispiel I wurden drei Schichten, einmal bestehend aus einem undotierten Matrixmaterial (HTM-014, Fa. Merck) sowie einer mit 5% und 15% Mo₂(O₂CCF₃)₄ dotierten Schicht HTM-014. Die Schichtdicke war jeweils 200nm.

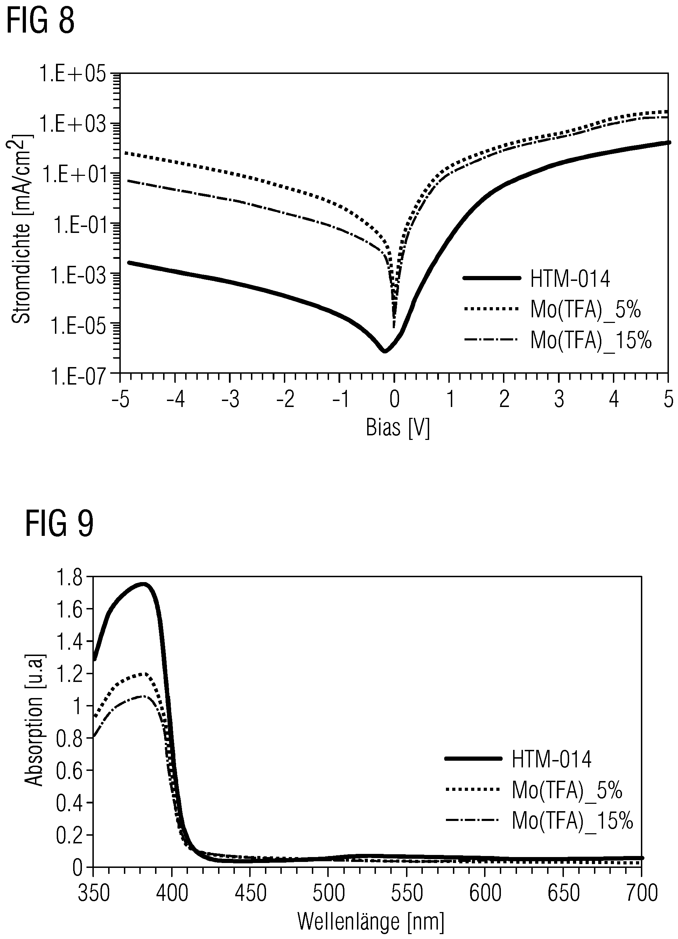

Fig. 8 zeigt die Stromdichte gegen die angelegte Spannung für die drei Materialien. Man sieht schon bei der 5% dotierten Schicht eine Erhöhung der Stromdichte gegen die angelegte Spannung.

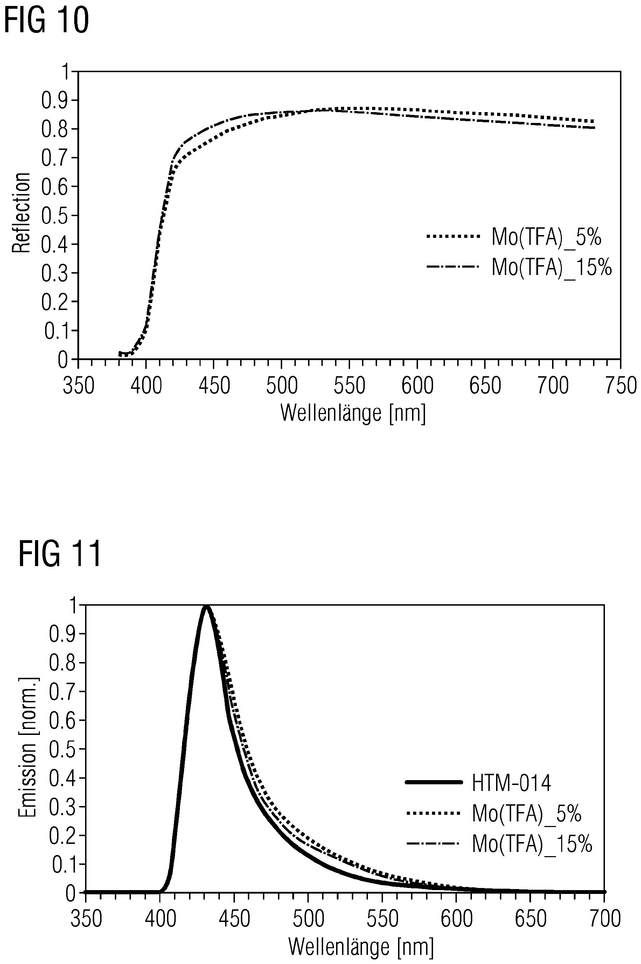

Zur Untersuchung der optischen Eigenschaften des erfindungsgemäßen Dotiermaterials wurden die Absorption, die Reflektion und die normierte Emission gemessen (Figuren 9 bis 11). Man sieht, dass die Komplexe nahezu transparent sind, was sie geeignet für einen Einsatz in (opto-)elektronischen Bauteilen macht.

Die einzelnen Kombinationen der Bestandteile und der Merkmale von den bereits erwähnten Ausführungen sind exemplarisch; der Austausch und die Substitution dieser Lehren mit anderen Lehren, die in dieser Druckschrift enthalten sind mit den zitierten Druckschriften werden ebenfalls ausdrücklich erwogen. Der Fachmann erkennt, dass Variationen, Modifikationen und andere Ausführungen, die hier beschrieben werden, ebenfalls auftreten können ohne von dem Erfindungsgedanken und dem Umfang der Erfindung abzuweichen.

Entsprechend ist die obengenannte Beschreibung beispielhaft und nicht als beschränkend anzusehen. Das in den Ansprüchen verwendete Wort umfassen schließt nicht andere Bestandteile oder Schritte aus. Der unbestimmte Artikel "ein" schließt nicht die Bedeutung eines Plurals aus. Die bloße Tatsache, dass bestimmte Maße in gegenseitig verschiedenen Ansprüchen rezitiert werden, verdeutlicht nicht, dass eine Kombination von diesen Maßen nicht zum Vorteil benutzt werden kann. Der Umfang der Erfindung ist in den folgenden Ansprüchen definiert und den dazugehörigen Äquivalenten.

## Patentansprüche

1. Organisches elektronisches Bauteil mit einer Matrix, **dadurch gekennzeichnet, dass** die Matrix als p-Dotand einen bi- oder polynuclearen Gruppe V b/ VI b / VII b bzw. Gruppe 5-7 Metallkomplex enthält, der mindestens einen Liganden L der folgenden Struktur enthält: 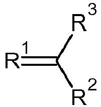
wobei R¹ und R² unabhängig voneinander Sauerstoff, Schwefel, Selen, NH oder NR⁴ sein können, wobei R⁴ ausgewählt ist aus der Gruppe enthaltend Alkyl oder Aryl und mit R³ verbunden sein kann; und
R³ ausgewählt ist aus der Gruppe enthaltend Alkyl, lineare und verzweigte C5-C20 Alkyle, Alkoxy, lineare und verzweigte C5-C20 Alkoxy, Cycloalkyl, Halogenalkyl, Aryl, Arylene, Halogenaryl, Heteroaryl, Heteroarylene, Heterocycloalkylene, Heterocycloalkyl, Halogenheteroaryl, Alkenyl, Halogenalkenyl, Alkinyl, Halogenalkinyl, Ketoaryl, Halogenketoaryl, Ketoheteroaryl, Ketoalkyl, Halogenketoalkyl, Ketoalkenyl, Halogenketoalkenyl, wobei bei geeigneten Resten eine oder mehrere nicht-benachbarte CH₂-Gruppen unabhängig voneinander durch -O-, -S-, -NH-, -CO-, -COO-, -OCO-, -OCO-O-, -S02-, - S-CO-, -CO-S-, -CY1=CY2 oder -C=C- ersetzt sein können und zwar derart, dass 0 und/oder S Atome nicht direkt miteinander verbunden sind, ebenfalls optional mit Aryl-oder Heteroaryl bevorzugt enthaltend 1 bis 30 C Atome ersetzt sind (endständige CH₃-Gruppen werden wie CH₂-Gruppen im Sinne von CH₂-H verstanden).

2. Bauteil nach Anspruch 1, wobei das Metall ausgewählt ist aus der Gruppe enthaltend Chrom, Molybdän, Wolfram oder Mischungen daraus.

3. Bauteil nach Anspruch 1 oder 2, wobei R³ ausgewählt ist aus der Gruppe enthaltend Halogenalkyl, Halogenaryl, Halogenalkylaryl, und Halogenheteroaryl.

4. Bauteil nach einem der Ansprüche 1 bis 3, wobei R³ ausgewählt ist aus der Gruppe enthaltend: 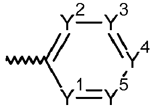 wobei Y¹ - Y⁵ unabhängig voneinander ausgewählt sind aus der Gruppe enthaltend C-F, C-CF₃ C-NO₂, C-CN, C-Halogen, C-Pseudohalogen oder N.

5. Bauteil nach einem der Ansprüche 1 bis 4, wobei R³ ausgewählt ist aus der Gruppe enthaltend: 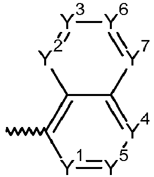 wobei Y¹ - Y⁷ unabhängig voneinander ausgewählt sind aus der Gruppe enthaltend C-F, C-CF₃, C-NO₂, C-CN, C-Halogen, C-Pseudohalogen oder N.

6. Bauteil nach einem der Ansprüche 1 bis 5, wobei R³ ausgewählt ist aus der Gruppe enthaltend: 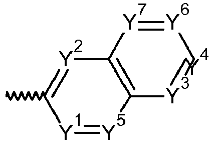 wobei Y¹ - Y⁷ unabhängig voneinander ausgewählt sind aus der Gruppe enthaltend C-F,CF₃, C-NO₂, C-CN, C-Halogen, C-Pseudohalogen oder N.

7. Bauteil nach einem der Ansprüche 1 bis 6, wobei der Metallkomplex mindestens einen Liganden L ausgewählt aus der Gruppe der nicht substituierten, partiell fluorierten oder per-fluorierten organischen Carbonsäuren enthält.

8. Bauteil nach einem der Ansprüche 1 bis 7, wobei der Metallkomplex mindestens einen Liganden L ausgewählt aus der Gruppe der nicht substituierten, partiell fluorierten oder per-fluorierten Essigsäure enthält.

9. Bauteil nach einem der Ansprüche 1 bis 8, wobei der Metallkomplex eine Schaufelradstruktur aufweist und Chrom oder Molybdän enthält und wobei R¹ und R² aus Sauerstoff bestehen.

## Claims

1. Organic electronic device comprising a matrix, **characterized in that** the matrix comprises as a p-dopant a bi- or polynuclear group V b / VI b / VII b or a group 5 - 7 metal complex which includes at least one ligand L of the following structure: 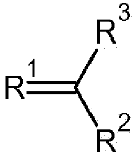
wherein R¹ and R² may independently be oxygen, sulphur, selenium, NH or NR⁴, wherein R⁴ is selected from the group comprising alkyl or aryl and may be connected to R³; and
R³ is selected from the group comprising alkyl, linear and branched C5 - C20 alkyls, alkoxy, linear and branched C5 - C20 alkoxy, cycloalkyl, haloalkyl, aryl, arylenes, haloaryl, heteroaryl, heteroarylenes, heterocycloalkylenes, heterocycloalkyl, haloheteroaryl, alkenyl, Haloalkenyl, alkynyl, haloalkynyl, ketoaryl, haloketoaryl, ketoheteroaryl, ketoalkyl, haloketoalkyl, ketoalkenyl, haloketoalkenyl, wherein with suitable residues, one or more non-adjacent CH₂ groups can be replaced independently of one another by -O-, -S-, -NH-, -CO-, -COO-, -OCO-, -OCO-O-, -SO₂-, -S-CO-, -CO-S-,-CY1=CY2- or -C≡C- in such a way that O and/or S atoms are not directly connected to each other, and optionally are replaced by aryl or heteroaryl preferably including 1 to 30 C atoms (terminal CH₃ groups are to be understood as CH₂ groups in the sense of CH₂-H).

2. Device according to claim 1, wherein the metal is selected from the group comprising chromium, molybdenum, tungsten or mixtures thereof.

3. Device according to claim 1 or 2, wherein R³ is selected from the group comprising haloalkyl, haloaryl, haloalkylaryl, and haloheteroaryl.

4. Device according to any one of claims 1 to 3, wherein R³ is selected from the group comprising: 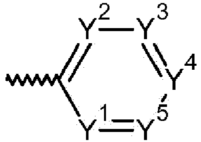 wherein Y¹ to Y⁵ are independently selected from the group comprising C-F, C-CF₃, C-NO₂, C-CN, C-halogen, C-pseudohalogen or N.

5. Device according to any one of claims 1 to 4, wherein R³ is selected from the group comprising: 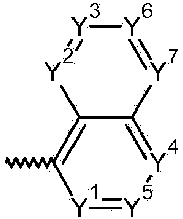 wherein Y¹ to Y⁷ are selected independently from the group comprising C-F, C-CF₃, C-NO₂, C-CN, C-halogen, C-pseudohalogen or N.

6. Device according to any one of claims 1 to 5, wherein R³ is selected from the group comprising: 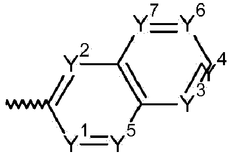 wherein Y¹ to Y⁷ are independently selected from the group comprising C-F, CF₃, C-NO₂, C-CN, C-halogen, C-pseudohalogen or N.

7. Device according to any one of claims 1 to 6, wherein the metal complex includes at least one ligand L selected from the group of unsubstituted, partially fluorinated or per-fluorinated organic carboxylic acids.

8. Device according to any one of claims 1 to 7, wherein the metal complex includes at least one ligand L selected from the group of unsubstituted, partially fluorinated or per-fluorinated acetic acids.

9. Device according to any one of claims 1 to 8, wherein the metal complex has a paddle wheel structure and includes chromium or molybdenum, and wherein R¹ and R² consist of oxygen.

## Revendications

1. Composant électronique organique doté d'une matrice, **caractérisé en ce que**
la matrice contient, en tant que dopant p, un complexe métallique bi ou polynucléaire des groupes Vb / VIb / VIIb, respectivement des groupes 5 à 7, qui contient au moins un ligand L selon la structure suivants : 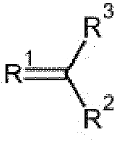
où R¹ et R² peuvent être indépendamment l'un de l'autre de l'oxygène, du soufre, du sélénium, un groupe NH ou NR⁴, où R⁴ est choisi dans le groupe contenant des groupes alkyles ou aryles et peut être relié à R³ ; et
R³ est choisi dans le groupe contenant le groupe alkyle, des groupes alkyles de C5 à C20 linéaires ou ramifiés, le groupe alcoxy, des groupes alcoxy de C5 à C20 linéaires ou ramifiés, le groupe cycloalkyle, le groupe halogéno-alkyle, le groupe aryle, le groupe arylène, le groupe halogèno-aryle, le groupe hétéroaryle, le groupe hétéro-arylène, le groupe hétéro-cycloalcylène, le groupe hétéro-cycloalkyle, le groupe halogèno-hétéroaryle, le groupe alcényle, le groupe halogéno-alcényle, le groupe alcinyle, le groupe halogèno-alcinyle, le groupe cétoaryle, le groupe halogéno-cétoaryle, le groupe céto-étheraryle, le groupe cétoalkyle, le groupe halogéno-cétoalkyle, le groupe cétoalcényle, le groupe halogéno-cétoalcényle, où, pour des radicaux appropriés, un ou plusieurs groupes CH₂ voisins peuvent être remplacés indépendamment les uns des autres par des groupes -O-, -S-, -NH-, -CO-, -COO-, -OCO-, -OCO-O-, -SO₂-, -S-CO-, -CO-S-, -CY¹=CY² ou -C≡C- et en l'occurrence de telle manière que les atomes 0 et/ou S ne soient pas directement reliés, de même, sont remplacés éventuellement avec des groupes aryles ou hétéroaryles contenant de préférence 1 à 30 atomes C (les groupes CH₃ terminaux sont considérés comme des groupes CH₂-H).

2. Composant selon la revendication 1, dans lequel le métal est choisi dans le groupe contenant le chrome, le molybdène, le tungstène ou des mélanges de ceux-ci.

3. Composant selon la revendication 1 ou 2, dans lequel R³ est choisi dans le groupe contenant les groupes halogéno-alkyle, halogéno-aryle, halogéno-alkylaryle et halogéno-hétéroaryle.

4. Composant selon l'une des revendications 1 à 3, dans lequel R³ est choisi dans le groupe contenant : 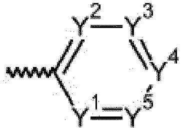 où Y¹ à Y⁵ sont choisis indépendamment les uns des autres dans le groupe contenant les groupements C-F, C-CF₃, C-NO₂, C-CN, C-halogène, C-pseudo halogène ou l'atome N.

5. Composant selon l'une des revendications 1 à 4, dans lequel R³ est choisi dans le groupe contenant : 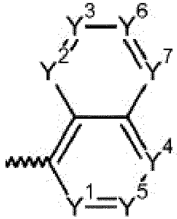 où Y¹ à Y⁷ sont choisis indépendamment les uns des autres dans le groupe contenant les groupements C-F, C-CF₃, C-NO₂, C-CN, C-halogène, C-pseudo halogène ou l'atome N.

6. Composant selon l'une des revendications 1 à 5, dans lequel R³ est choisi dans le groupe contenant : 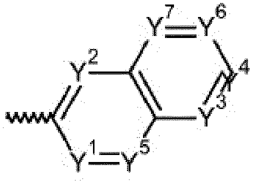 où Y¹ à Y⁷ sont choisis indépendamment les uns des autres dans le groupe contenant les groupements C-F, C-CF₃, C-NO₂, C-CN, C-halogène, C-pseudo halogène ou l'atome N.

7. Composant selon l'une des revendications 1 à 6, dans lequel le complexe métallique contient au moins un ligand L choisi dans le groupe des acides carboniques organiques non substitués, partiellement fluorés ou perfluorés.

8. Composant selon l'une des revendications 1 à 7, dans lequel le complexe métallique contient au moins un ligand L choisi dans le groupe de l'acide acétique non substitué, de l'acide acétique partiellement fluoré ou de l'acide acétique perfluoré.

9. Composant selon l'une des revendications 1 à 8, dans lequel le complexe métallique présente une structure de roue à aubes et contient du chrome ou du molybdène et où R¹ et R² sont constitués d'oxygène.
